(19) **Europäisches Patentamt / European Patent Office / Office européen des brevets**

(11) **EP 1 455 269 B1**

(12) **EUROPEAN PATENT SPECIFICATION**

(45) Date of publication and mention
of the grant of the patent:
**18.03.2009 Bulletin 2009/12**

(51) Int Cl.:
*G06F 7/48* (2006.01)     *H03M 7/00* (2006.01)

(21) Application number: **04004878.7**

(22) Date of filing: **02.03.2004**

(54) **bit length reduction avoiding cumulative error**

Vermeidung von kumulativen Fehlern bei Bitlängereduzierung

Réduction de longueur de bit évitant une erreur cumulative

(84) Designated Contracting States:
**DE FR GB IT**

(30) Priority: **04.03.2003 JP 2003056912**

(43) Date of publication of application:
**08.09.2004 Bulletin 2004/37**

(73) Proprietor: **Sony Corporation**
**Tokyo (JP)**

(72) Inventor: **Eguchi, Takeo**
**Shinagawa-ku**
**Tokyo (JP)**

(74) Representative: **Müller - Hoffmann & Partner**
**Patentanwälte**
**Innere Wiener Strasse 17**
**81667 München (DE)**

(56) References cited:
**US-A- 4 272 648**     **US-A1- 2002 087 610**
**US-B1- 6 369 731**

• **NAOKI MIKAMI ET AL: "ROUNDOFF-ERROR REDUCTION FOR EVALUATION OF A FUNCTION BY POLYNOMIAL APPROXIMATION WITH ERROR FEEDBACK IN FIXED-POINT ARITHMETIC" IEEE TRANSACTIONS ON SIGNAL PROCESSING, IEEE SERVICE CENTER, NEW YORK, NY, US, vol. 41, no. 5, 1 May 1993 (1993-05-01), pages 1953-1955, XP000368385 ISSN: 1053-587X**

**Description**

BACKGROUND OF THE INVENTION

1. Field of the Invention

The present invention relates to a signal processing apparatus, a program for use in a signal processing apparatus, a storage medium storing thereon a program for use in a signal processing apparatus, and a signal processing method, for converting a continuous signal such as image information or audio information into other information by means of digital conversion such as filtering or level adjusting.

2. Description of the Related Art

In a conventional signal processing apparatus designed to be used for such a purpose, when data obtained as a result of an operation performed on given input data has a longer bit length than that of the input data, it is necessary to adjust the resultant data so as to have the same bit length as that of the input data.

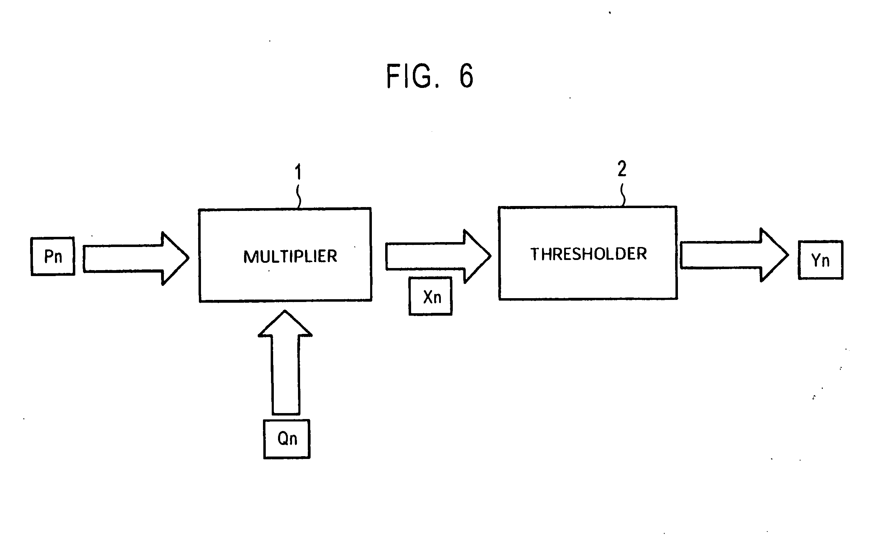

Fig. 6 is a diagram illustrating an example of a process for the above-described purpose. In Fig. 6, Pn is input data that has been converted into digital form, and Qn is data according to which to control Pn. In general, Qn is less than 1. Pn and Qn are input to a multiplier 1, and Xn (= Pn x Qn) is output. In general, Xn has a bit length equal to the sum of the bit length of input data Pn and the bit length of Qn.

To avoid a problem with the difference in bit length between the output data Xn and the input data Pn, it is necessary to convert the output data Xn so as to have the same bit length as that of the input data Pn.

To this end, Xn is input to a thresholder 2 to shorten the bit length. As a result, output data Yn having a properly adjusted bit length is obtained. Note that the bit length of the output data Yn does not necessarily need to be the same as that of the input data Pn.

The thresholding described above can be performed by (1) unconditional rounding down, (2) unconditional round up, or (3) rounding off (rounding up or down depending on a given value).

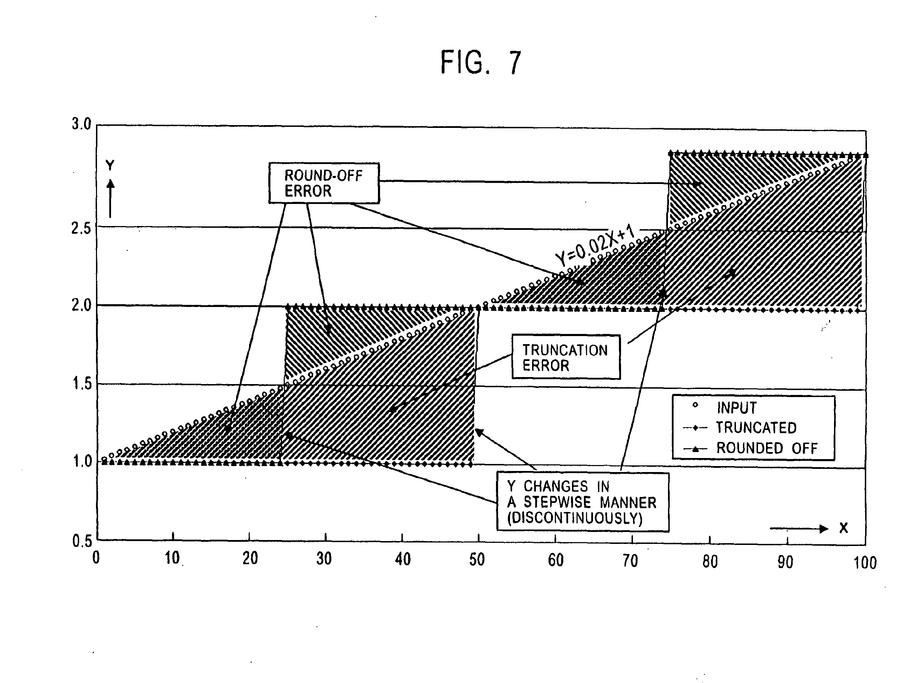

For example, when X is given as an input value, if operation Y = 0.02X + 1 is performed on X and the resultant value of Y is rounded down or rounded off to an integer, the output value is obtained as shown in Fig. 7 (the output value obtained by means of rounding up is not shown in Fig. 7) .

In the case of rounding off, the integral value obtained by rounding off Y is 1 for the input value smaller than 25, but the integral value jumps to 2 when the input value X becomes 25. As can be seen from Fig. 7, the integral value obtained by rounding off or rounding down the calculated value Y changes in a stepwise fashion (in a discontinuous fashion).

In the above-described conventional technology, the final output value includes a more or less error whichever technique of (1) rounding down, (2) rounding up, or (3) rounding off is used. In the case of rounding off, if errors are averaged over a long period, the averaged error becomes 0. In contrast, when rounding-down is used, each output value includes an error of 0.5 on average. Even in the case of rounding off, if output values are not averaged, a great error occurs for values close to each discontinuous transition point. In the case in which the input value X varies linearly as in the example described above, the error alternately increases and decreases as the input value X varies. However, when the input value X varies within a narrow range close to a transition point, or when the input value X varies at a low rate, the rounded value of Y includes a large error and remains unchanged for a long period.

Furthermore, when there is a range difference in bit length between the input data and the output data, the cumulative value of the output data can have a great cumulative error with respect to the cumulative value of the input data. When a large cumulative error causes a problem, signal processing is performed using a large number of bits such that the error arising via the signal processing is minimized and such that the cumulative error does not cause the output data to be biased in a particular direction.

Whether the error causes a problem or not depends on the bit length of the output data and on for what purpose the output data is used. In general, the bit length used in the signal processing is determined such that the error falls within an allowable range.

That is, the error can be reduced to a sufficiently small range by increasing the bit length used in the signal processing or by increasing the memory capacity.

However, in some cases, it is not allowed to increase the bit length to reduce the error (that is, in some applications, it is required to perform signal processing using a limited number of bits). For example, in some applications, only on-off processing is allowed. In some other applications, on-off processing is more desirable to achieve a high energy efficiency although continuous processing is also allowed.

In some applications such as level adjustment of digital audio data or contrast adjustment of digital image data, if the dynamic range is reduced as a result of level adjustment or contrast adjustment, the reduction in dynamic range causes a reduction in the number of bits that can be used to represent signals in the reduced dynamic range becomes smaller. This means that the relative error with respect to the signal increases as the signal level decreases.

In thermal ink-jet printers, a fixed amount of ink droplet is emitted at a time and the amount of ink droplet emitted at a time cannot be changed. That is, when an ink image is formed on a recording medium, emission of ink at each dot is performed by means of two-level control in which a fixed amount of ink droplet is emitted or no ink is emitted. To achieve halftone representation using two-level ink emission at each dot, the density of inked dots per unit area is modulated. To this end, error diffusion or dithering is widely used. However, to achieve good enough halftone representation, complicated computation is needed, and thus a complicated circuit and a long computation time are required.

In US 4,272,648, a gain control apparatus for digital telephone line circuits is disclosed. The gain control is positioned in the circuit to respond to a digital signal manifesting a plurality of words, each having a given number of bits N and indicative of a weighted value of an analog signal. The digital signal is multiplied by a word coefficient having a number of bits M indicative of a gain factor to be imparted to the digital signals. A product signal is provided containing M+N bits. The least significant bits are removed to provide an output signal of N bits possessing the desired gain. The discarded bits are employed via a feedback loop and are added to the next word product, which is then used to provide a next output signal. The feedback loop assures that each output signal is a close approximation to the input signal as gain controlled by the desired gain factor.

## SUMMARY OF THE INVENTION

An object of the present invention is to provide a technique to perform signal processing without creating significant degradation in smoothness or frequency characteristics, even if the bit length is reduced when an input digital signal is processed.

In an aspect, to achieve the above object, the present invention provides a signal processing apparatus for receiving digital signals according to claim 1.

In this signal processing apparatus according to the present invention, an error arising via rounding-off processing is calculated by the difference calculation means, and the error or a value obtained by performing the predetermined operation on the error is added to a next input digital signal via the feedback means.

Because each error is fed back in such a manner that an error arising via an operation performed on an input digital signal is added to a next input digital signal, an error arising via an operation performed on the next input digital signal is added to a further next input digital signal, and so on, accumulation of errors is prevented.

## BRIEF DESCRIPTION OF THE DRAWINGS

Fig. 1 is a block diagram illustrating a signal processing apparatus according to a first embodiment of the present invention;

Fig. 2 is a diagram illustrating, in the form of a graph, an operation result;

Fig. 3 is a graph showing results of operations (operation A and operation B) that are similar to the operation shown in Fig. 2 and that are performed simultaneously such that there is a phase difference between them;

Fig. 4 is a diagram showing examples of images formed by controlling the density of dots per unit area using the process according to the present invention;

Fig. 5 is a block diagram of a signal processing apparatus according to a second embodiment of the present invention;

Fig. 6 is a diagram showing a data processing method according to a conventional technique; and

Fig. 7 is a graph showing the relationship between input and output values for a case in which the fractional portions of input values are discarded and for a case in which input values are rounded off to nearest integers.

## DESCRIPTION OF THE PREFERRED EMBODIMENTS

The present invention is described in further detail below with reference to specific embodiments in conjunction with the accompanying drawings.

First Embodiment

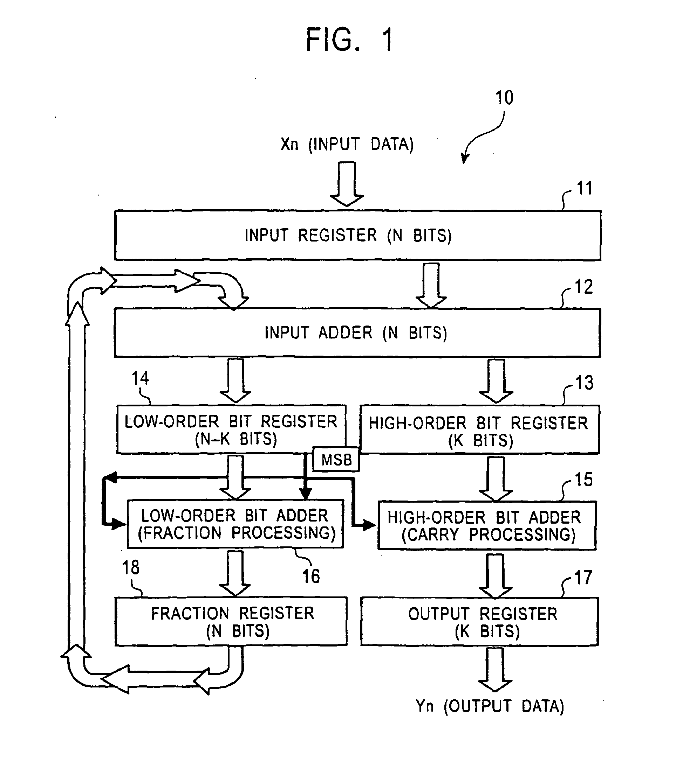

Fig. 1 is a block diagram showing a signal processing apparatus according to a first embodiment of the present invention. Although in the present embodiment, the signal processing apparatus 10 shown in Fig. 1 is to be realized by hardware (for example, in the form of a signal processing circuit). All registers such as a register 11 shown in Fig. 1 operate in synchronization with the same clock signal.

In the present embodiment, by way of example, each input data X is subjected to an operation (performed by calculation means according to the present invention) according to the following equation:

$$Y = 0.02X + 1.$$

A high-order part of a value obtained as a result of the above operation is extracted by rounding off the value to an integer (by high-order part extraction means according to the present invention), and a residual fraction is dealt with as an error.

In Fig. 1, an N-bit digital signal is input to the input register 11. The digital signal input to this input register 11 is transferred to an input adder 12. To the input adder 12, an error generated in a previous operation is also input. The input digital signal and the input error are added by the input adder 12.

The addition result is output to a high-order bit register 13 and a low-order bit register 14.

As shown in Fig. 1, if K bits of the input N-bit digital signal Xn is output to the high-order bit register 13, then the number of bits output to the low-order bit register 14 is (N - K) bits.

Thereafter, it is determined whether the value output from the low-order bit register 14 is equal to or greater than 0.5. If the value output from the low-order bit register 14 is equal to or greater than 0.5, the value is rounded up to the high-order bit value by adding 1 to the high-order bit adder 15. As a result, 1 is added to the value output from the high-order bit register 13.

When 1 is input to the high-order bit adder 15, the error resulting from the rounding up is input to the low-order bit adder 16 (by difference calculation means according to the present invention). For example, if the value output from the low-order bit register 14 is 0.7, then it is determined that the value output from the low-order bit register 14 is greater than 0.5, and 1 is input to the high order bit adder 15. In this specific case, the error resulting from the rounding up is -0.3, and -0.3 is input to the low-order bit adder 16.

When rounding up is performed, if the value output from the low-order bit register 14 is P, then

$$(1 - P) \times (-1)$$

is calculated and the resultant value is input to the low-order bit adder 16.

On the other hand, when it is determined that the value output from the low-order bit register 14 is smaller than 0.5, 1 is not input to the high order bit adder 15, but the value (fraction part) output from the low-order bit register 14 is directly input to the low-order bit adder 16 (by the difference calculation means according to the present invention).

Thus, rounding off to the extracted integer part is performed via the above-described process.

A K-bit value output from the high order bit adder 15 is sent to an output register 17 and output as data Yn therefrom.

On the other hand, the output value from the low-order bit adder 16 is input to the fraction processing register 18, which in turn converts the received fractional value into a value with a predetermined number of bits (a predetermined number of decimal places). The resultant value is input to the input adder 12 thereby feeding back the error (by feedback means according to the present invention).

The process described above is described in further detail below.

Herein, it is assumed that input values are given in the form of a sequence of continuous real numbers {X1, X2, X3, ....}.

Each of the real numbers X1, X2,... consists of an integer part A and a fraction part B. That is, each real number can be expressed as

$$Xn = An + Bn$$

Let Yn be an output value obtained by rounding off Xn to an integer. For example, when X1 is given as

$$X1 = A1 + B1$$

then Y1 is given by

$$Y1 = [X1]$$

$$= \begin{cases} A1 & \text{(when } B1 < 0.5) \\ A1+1 & \text{(when } 0.5 \leq B1 < 1) \end{cases}$$

where [Xn] denotes the operation of rounding off Xn to a particular digit (in the present embodiment, a fractional part is rounded off to an integer).

If Y1 = A1 (that is, if rounding up does not occur), then

$$Y2 = [X2 (= A2 + B2) + B1]$$

$$= \begin{cases} A2 & \text{(when } B2 + B1 < 0.5) \\ A2+1 & \text{(when } 0.5 \leq B2 + B1 < 1) \end{cases}$$

On the other hand, when Y1 = A1 + 1 (that is, when rounding up occurs),

$$Y2 = [X2 (= A2 + B2) + (B1 - 1)]$$

$$= \begin{cases} A2 & \text{(when } B2 + B1 - 1 < 0.5) \\ A2+1 & \text{(when } 0.5 \leq B2 + B1 - 1 < 1) \end{cases}$$

All Yn are determined one by one in the above-described manner.

In the present embodiment, an error created as a result of rounding off is handled (added) when a next value is input. For example, if rounding up occurs in the calculation of Y1, Y1 is given by

$$Y1 = A1 + 1$$

Herein, although Y1 is greater than the actual input value X1, the error is subtracted when next value Y2 is determined. Therefore, this error is completely cancelled out in Y1 + Y2.

Thus, when Y1, Y2,..., Yn are determined one by one, the sum of thereof (Y1 + Y2 +... + Yn) is given by

$$\text{SUM(Yn)} = (A1 + 1^*) + (A2 + 1^*) + (A3 + 1^*) + \ldots + (An + 1^*) + (B1 - 1^*)$$
$$+ (B2 - 1^*) + (B3 - 1^*) + \ldots + (Bn - 1^*)$$
$$= X1 + X2 + X3 + \ldots + Xn$$

where 1* takes 1 only when a carry appears as a result of rounding off.

In the above equation, (A1 + 1*) to (An + 1*) are integer parts, and (B1 - 1*) to (Bn - 1*) are fraction parts.

In the above equation, if 1* takes 1 (that is, if a carry appears), for example, in term A1, then 1* takes 1 also in term B1. Therefore, when Y1, Y2,..., Yn are added together, errors arising from rounding off are all cancelled out (that is, errors are not accumulated).

Thus, the sum of Yn (output values) becomes equal to the sum of Xn (input values).

Thus, when data to be processed is continuous, theoretically, no error occurs if the processing is performed using a large enough number of bits.

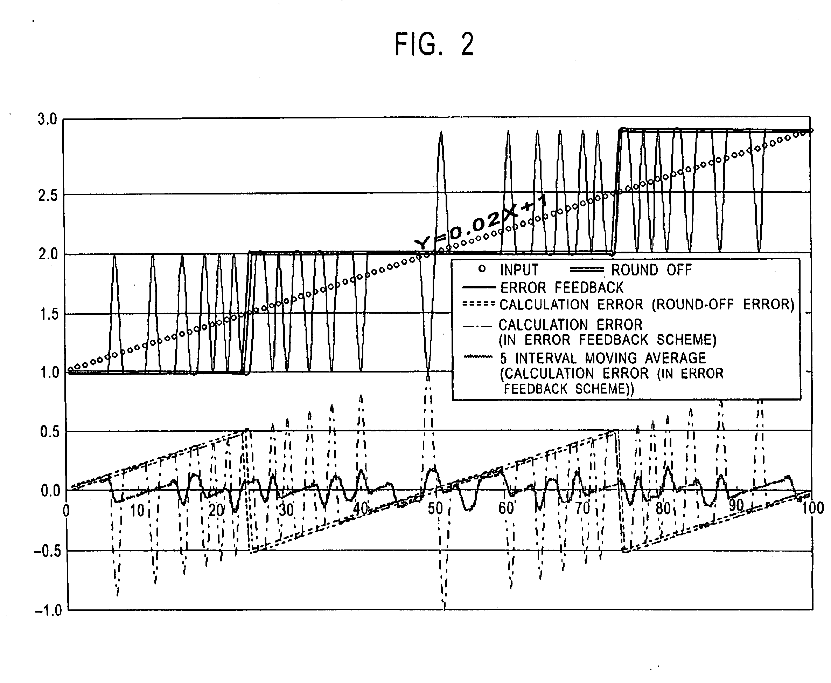

Fig. 2 shows, in the form of a graph, the result obtained when

$$Y = 0.02X + 1$$

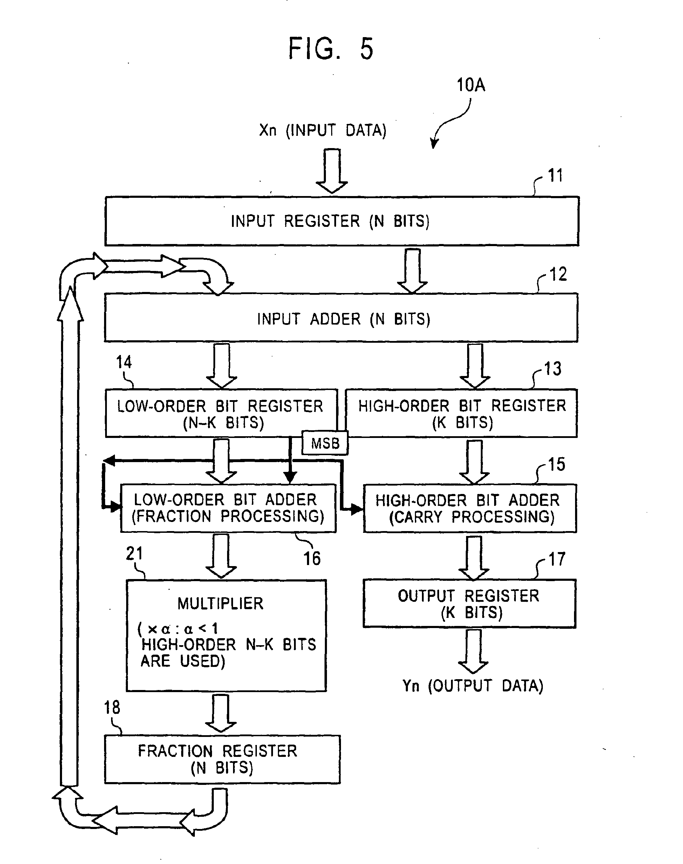

is calculated in the above-described manner. In Fig. 5, for the purpose of comparison, the result obtained when the calculation is performed according to the conventional rounding-off scheme is also shown.

As shown in Fig. 2, in the simple rounding off scheme, the output does not change unless the factional part of an input value reaches a threshold value. In contrast, in the scheme according to the present embodiment, each fractional value arising as a result of rounding off is added to a next input value, and thus the output value changes frequently. The frequency of the change is proportional to the difference between the input value and the output value, that is, the absolute value of the error. The output value, which changes back and forth between two values, can be smoothed by means of averaging using a filter or the like.

Although the error arising as a result of rounding off in each calculation can be twice the error that occurs in the conventional rounding off scheme, the moving average taken over a plurality of inputs X has a small error because the output changes when the input changes in a small range. In Fig. 2, the moving average taken over successive five points is shown. This curve indicates that the moving average changes within a small range.

In the scheme according to the present embodiment, as described above, in a range in which an error becomes great, the output value frequently changes back and forth between two values, and thus an averaged value becomes equal to the median of the two values. Furthermore, because the majority of error components lie in a high frequency range, it is possible to easily remove the high-frequency components (errors) from the output simply by passing the output through a simple (low-order) lowpass filter.

Another example of the process of feeding back an error from the fraction processing register 18 to the input adder 12 is described below.

In the case in which continuous digital signals are sequentially input, errors can be well handled by feeding back the error via the input adder 12 in the above-described manner.

However, when inputs are given in the form of $Xn = An + Bn$, if inputting is stopped, a new fraction part $Bn$ does not occur, and a current fraction part $Bn$ to be added to a next input value remains without being added until the next input value $Xn$ is actually given.

However, in this case, the fraction part $Bn$ has no correlation with the next input value, and thus preserving of the fraction part $Bn$ is not only meaningless but can be harmful depending on the next input value $Xn$.

For example, when a next input value $Xn$ is very close to $Yn$ and thus no error should appear in $Yn$, if an error greater than 0.5 remains, the output value becomes different from the expected value (that is, $Xn + 1$ or $Xn - 1$ is output).

One technique to avoid the above problem is to reset the error (to be added to a next input value) stored in the fraction processing register 18 to zero, when the next input value $Xn$ becomes zero after the operation of a sequence of digital signals (a first set of digital signals) is completed.

In this technique, when a next sequence of digital signals (a second set of digital signals) $Xn$ is input, the operation is started from an initialized state.

Contrary to the above, a value stored in the fraction processing register 18 may be used to create a particular effect on the next operation. For example, when two operations are simultaneously performed under the control of the same clock signal, results can be output such that they have a particular relationship (for example, results are output not at the same time but at periodically shifted times or positions).

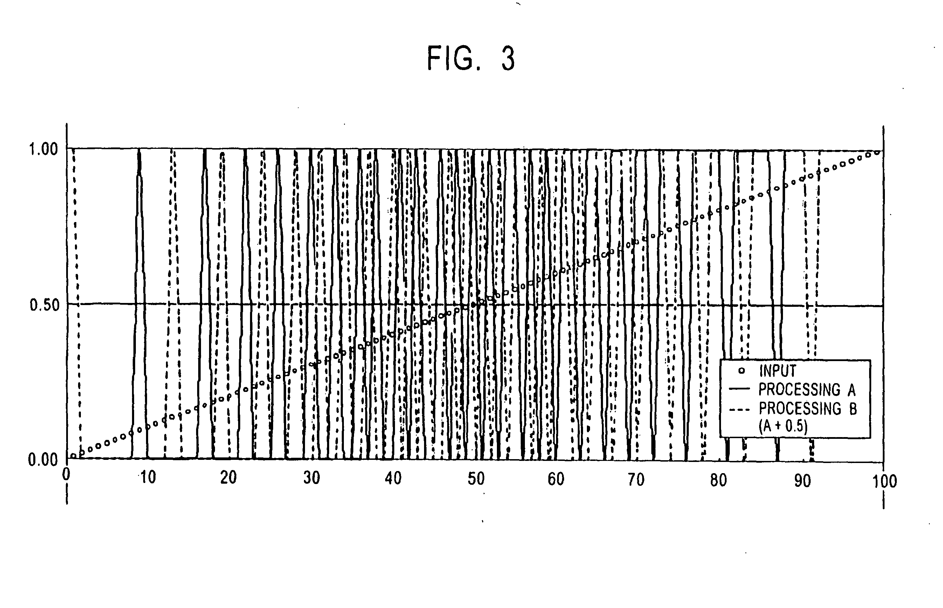

Fig. 3 is a graph showing results of operations (operation A and operation B) that are similar to the operation shown in Fig. 2 and that are performed simultaneously such that there is a phase difference between them. In Fig. 3, a solid line represents an operation A, and a broken line represents an operation B (A + 0.5).

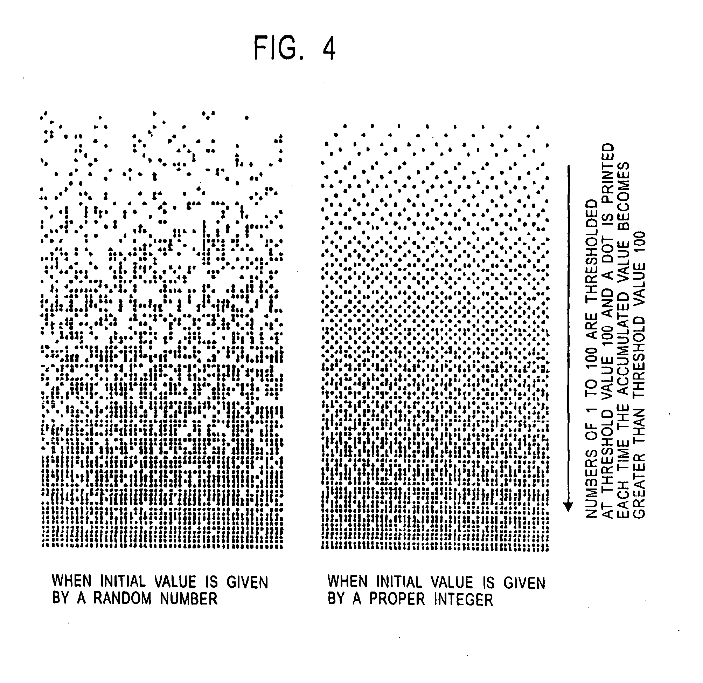

Fig. 4 shows examples of images formed by controlling the density of dots per unit area using the process described above. In Fig. 4, values varying in units of steps from 1 to 100 are input, and the input values are binarized by thresholding them with respect to 100. Each time the sum of fed-back errors becomes greater than 100, a dot is formed. In Fig. 4, a time axis is taken in a direction denoted by an arrow (from up to down). That is, dots are formed from up to down in Fig. 4. 50 sequences of dots are obtained via independent processing, and results are shown in Fig. 4 such that sequences of dots are shifted sequence by sequence in a horizontal direction.

In 50 sequences of dots shown on the left-hand side of Fig. 4, random values from 1 to 100 are given as 50 initial values (located in a horizontal line at the top).

On the other hand, in 50 sequences of dots shown on the right-hand side of Fig. 4, a repetition of 6 values (properly ordered integral multiples 16, that is, 16, 32, 48, 64, 80, and 96) is given as initial values.

As can be seen from Fig. 4, when a plurality of operations are performed in parallel as in image processing, it is possible to change the initial phases by controlling the initial values thereby achieving desirable effects.

Second Embodiment

Fig. 5 is a block diagram showing a signal processing apparatus (signal processing apparatus 10A) according to a second embodiment of the present invention.

In the second embodiment, unlike the first embodiment described above with reference to Fig. 1 in which each fractional value (error) is directly added to a next input value Xn, the fractional value is added via a multiplier 21. That is, the fractional value output from the low-order bit adder 16 is input to the multiplier 21 and multiplied by a constant $\alpha$ (for example, 0.75) smaller than 1.

If Xn is not input for a long period, the fractional value is reduced at each operation interval, and thus the fractional value decreases toward zero. Therefore, when Xn is input after a long period during which no Xn is input, an error (a fraction) added to the input value Xn has become very small, and thus the operation is performed in a state substantially identical to the initial state, although the very small error added to the input value Xn.

In the present embodiment, because errors that occur during the operation are fed back such that each error is added to a next input value Xn, error components occurring during the operation lie in a high frequency range. If the output including the error components is oversampled at a frequency higher than twice the Nyquist frequency, the error components are shifted to a further higher frequency range. This makes it possible to easily remove the high frequency components from the output by passing the output through a low-order lowpass filter without causing a significant loss of a desired signal component.

The signal processing apparatus 10 or 10A described above may be used not only to threshold a given signal with respect to a single reference value without creating a significant error, but also to threshold a given signal with respect to two or more reference values. Specific examples to which the signal processing apparatus according to the present invention can be applied include (1) power control (illumination control, temperature control, motion control, etc.), (2) measurement and indication of measurement result (meters), and (3) droplet emission control (ink-jet printers or the like).

The signal processing apparatus according to the present invention is essentially different from that based on the error diffusion method, as described below.

The error diffusion method is used mainly in image processing in which two-dimensional data is dealt with. In contrast, the signal processing method according to the present invention is basically used to process a sequence of one-dimensional data.

In the error diffusion method, errors are weighted and weighted errors are added to a plurality of adjacent data (that is, errors are diffused two-dimensionally).

In contrast, in the present invention, an error is simply added to a next input value. Furthermore, in the present invention, an initial value may by arbitrarily set, for example, by preloading the initial value.

Furthermore, unlike the error diffusion method, the present invention does not need a high-capacity memory, and operation can be performed in a short time.

Although the present invention has been described above with reference to specific embodiments, the present invention as claimed is not limited to the details of those embodiments, but various modifications are possible.

For example, rounding off can be performed at an arbitrary digit. Which part is to be extracted as a high-order part by means of rounding off may be set arbitrarily. Both the high-order part and the low-order part may be decimals. Conversely, both may be integers.

As described above, the present invention makes it possible to improve the calculation accuracy in signal processing and reduce the calculation time, without needing either an increase in memory capacity or an increase in cost.

**Claims**

1. A signal processing apparatus (10, 10a) for receiving digital signals that are continuously related and input sequentially, performing a predetermined operation on each of sequentially input digital signals (Xn), and outputting a result of the operation, the signal processing apparatus (10. 10a) comprising:

   operation means for performing the predetermined operation on an input digital signal (Xn);
   high-order part extraction means for extracting a necessary high-order part by rounding off a result of the operation performed by the operation means;
   difference calculation means for calculating the difference between the result of the operation performed by the operation means and the high-order part extracted by the high-order part extraction means; and
   feedback means comprising an adder for adding, to a next input digital signal (Xn), the difference value calculated by the difference calculation means or a value obtained by performing a predetermined operation on the difference value calculated by the difference calculation means,

**characterized in that**

wherein when a second set of continuously-related digital signals is sequentially input after completion of inputting of a first set of continuously-related digital signals, a difference value obtained as a result of the difference calculation performed, by the difference calculation means, on the last digital signal of the first set of digital signals or a value obtained by performing the predetermined operation on the difference value calculated by the difference means is reset to 0, when the next input value (Xn) becomes zero after the operation of the first set of digital signals" and the resultant value is added, via the feedback means, to the first digital signal of the second digital signals.

2. A signal processing apparatus (10, 10a) according to claim 1, wherein the feedback means adds, to the next input digital signal (Xn), a value obtained by multiplying the difference value calculated by the difference calculation means by a factor smaller than 1.

3. A signal processing apparatus (10, 10a) according to claim 1, wherein a digital signal acquired by means of oversampling is input to the operation means.

**Patentansprüche**

1. Signalverarbeitungsvorrichtung (10, 10a) zum Empfangen digitaler Signale, die in kontinuierlicher Beziehung stehen und sequenziell eingegeben werden, um an jedem der sequenziell eingegebenen digitalen Signale (Xn) eine vorbestimmte Operation auszuführen und das Operationsergebnis auszugeben, mit:

einer Operationseinrichtung zum Ausführen der vorbestimmten Operation an einem eingegebenen digitalen Signal (Xn);
einer Teil-hoher-Ordnung-Entnahmeeinrichtung zum Entnehmen eines erforderlichen Teils hoher Ordnung durch Abrunden des Ergebnisses der durch die Operationseinrichtung ausgeführten Operation;
einer Differenzberechnungseinrichtung zum Berechnen der Differenz zwischen dem Ergebnis der durch die Operationseinrichtung ausgeführten Operation und dem durch die Teil-hoher-Ordnung-Entnahmeeinrichtung entnommenen Teil hoher Ordnung; und
einer Rückführeinrichtung mit einem Addierer zum Addieren, zum nächsten eingegebenen digitalen Signal (Xn), des durch die Differenzberechnungseinrichtung berechneten Differenzwerts oder eines Werts, der **dadurch** erhalten wurde, dass am durch die Differenzberechnungseinrichtung berechneten Differenzwert eine vorbestimmte Operation ausgeführt wurde;
**dadurch gekennzeichnet, dass**
dann, wenn ein zweiter Satz in kontinuierlicher Beziehung stehender digitaler Signale nach Abschluss der Eingabe des ersten Satzes in kontinuierlicher Beziehung stehender digitaler Signale sequenziell eingegeben wird, ein Differenzwert, der als Ergebnis der durch die Differenzberechnungseinrichtung ausgeführten Differenzberechnung für das letzte digitale Signal des ersten Satzes digitaler Signale erhalten wird, oder ein Wert, der **dadurch** erhalten wird, dass die vorbestimmte Operation am durch die Differenzeinrichtung berechneten Differenzwert ausgeführt wird, auf 0 gesetzt wird, wenn der nächste eingegebene Wert (Xn) nach der Operation am ersten Satz digitaler Signale null wird, und der sich ergebende Wert über die Rückführeinrichtung zum ersten digitalen Signal der zweiten digitalen Signale addiert wird.

2. Signalverarbeitungsvorrichtung (10, 10a) nach Anspruch 1, bei der die Rückführeinrichtung zum als nächstem eingegebenen digitalen Signal (Xn) den Wert addiert, der **dadurch** erhalten wird, dass der durch die Differenzberechnungseinrichtung berechnete Differenzwert mit einem Faktor kleiner 1 multipliziert wird.

3. Signalverarbeitungsvorrichtung (10, 10a) nach Anspruch 1, bei der in die Operationseinrichtung ein digitales Signal eingegeben wird, das durch Überabtasten erfasst wurde.

**Revendications**

1. Dispositif (10, 10a) de traitement de signaux destiné à recevoir des signaux numériques qui sont liés de manière continue et qui entrent séquentiellement, à effectuer une opération prédéterminée sur chacun des signaux numériques (Xn) entrés séquentiellement, et à sortir un résultat de l'opération, le dispositif (10, 10a) de traitement de signaux comprenant :

un moyen d'opération destiné à effectuer l'opération prédéterminée sur un signal numérique (Xn) entré ;

un moyen d'extraction de partie de poids fort destiné à extraire une partie de poids fort nécessaire en arrondissant au plus près le résultat de l'opération effectuée par le moyen d'opération ;

un moyen de calcul de différence destiné à calculer la différence entre le résultat de l'opération effectuée par le moyen d'opération et la partie de poids fort extraite par le moyen d'extraction de partie de poids fort ; et

un moyen de rétroaction comprenant un additionneur destiné à ajouter, au signal numérique (Xn) entré suivant, la valeur de différence calculée par le moyen de calcul de différence ou une valeur obtenue en effectuant une opération prédéterminée sur la valeur de différence calculée par le moyen de calcul de différence ;

**caractérisé en ce que**, lorsqu'un deuxième ensemble de signaux numériques liés de manière continue entre séquentiellement après la fin de l'entrée d'un premier ensemble de signaux numériques liés de manière continue, une valeur de différence obtenue comme résultat du calcul de différence effectué, par le moyen de calcul de différence, sur le dernier signal numérique du premier ensemble de signaux numériques ou bien une valeur obtenue en effectuant l'opération prédéterminée sur la valeur de différence calculée par le moyen de différence est remise à 0, lorsque la valeur (Xn) entrée suivante devient zéro après l'opération du premier ensemble de signaux numériques, et **en ce que** la valeur résultante est ajoutée, via le moyen de rétroaction, au premier signal numérique des deuxièmes signaux numériques.

2. Dispositif (10, 10a) de traitement de signaux selon la revendication 1, dans lequel le moyen de rétroaction ajoute, au signal numérique (Xn) entré suivant, une valeur obtenue en multipliant, par un facteur plus petit que 1, la valeur de différence calculée par le moyen de calcul de différence.

3. Dispositif (10, 10a) de traitement de signaux selon la revendication 1, dans lequel on entre dans le moyen d'opération un signal numérique acquis au moyen d'un suréchantillonnage.

# FIG. 1

10

Xn (INPUT DATA)

11

INPUT REGISTER (N BITS)

12

INPUT ADDER (N BITS)

14

LOW-ORDER BIT REGISTER
(N–K BITS)

13

HIGH-ORDER BIT REGISTER
(K BITS)

MSB

LOW-ORDER BIT ADDER
(FRACTION PROCESSING)

15

HIGH-ORDER BIT ADDER
(CARRY PROCESSING)

18

16

FRACTION REGISTER
(N BITS)

17

OUTPUT REGISTER
(K BITS)

Yn (OUTPUT DATA)

10

# FIG. 2

Legend:
- ○ INPUT
- ═══ ROUND OFF
- ── ERROR FEEDBACK
- ═════ CALCULATION ERROR (ROUND-OFF ERROR)
- ─·─ CALCULATION ERROR (IN ERROR FEEDBACK SCHEME)
- ∿∿∿ 5 INTERVAL MOVING AVERAGE (CALCULATION ERROR (IN ERROR FEEDBACK SCHEME))

Y=0.02X+1

EP 1 455 269 B1

FIG. 3

Legend: ○ INPUT — PROCESSING A --- PROCESSING B (A + 0.5)

FIG. 4

NUMBERS OF 1 TO 100 ARE THRESHOLDED
AT THRESHOLD VALUE 100 AND A DOT IS PRINTED
EACH TIME THE ACCUMULATED VALUE BECOMES
GREATER THAN THRESHOLD VALUE 100

WHEN INITIAL VALUE IS GIVEN
BY A PROPER INTEGER

WHEN INITIAL VALUE IS GIVEN
BY A RANDOM NUMBER

# FIG. 5

10A

Xn (INPUT DATA)

**INPUT REGISTER (N BITS)** — 11

**INPUT ADDER (N BITS)** — 12

14
**LOW-ORDER BIT REGISTER (N–K BITS)**

MSB

**HIGH-ORDER BIT REGISTER (K BITS)** — 13

**LOW-ORDER BIT ADDER (FRACTION PROCESSING)** — 16

**HIGH-ORDER BIT ADDER (CARRY PROCESSING)** — 15

21
**MULTIPLIER**

( $\times \alpha : \alpha < 1$
HIGH-ORDER N–K BITS
ARE USED)

**OUTPUT REGISTER (K BITS)** — 17

Yn (OUTPUT DATA)

18
**FRACTION REGISTER (N BITS)**

FIG. 6

EP 1 455 269 B1

## FIG. 7

EP 1 455 269 B1

**EP 1 455 269 B1**

## REFERENCES CITED IN THE DESCRIPTION

### Patent documents cited in the description

- US 4272648 A